(19) Europäisches Patentamt
European Patent Office
Office européen des brevets

(11) **EP 3 512 213 A1**

(12) **EUROPEAN PATENT APPLICATION**

(43) Date of publication:
**17.07.2019 Bulletin 2019/29**

(51) Int Cl.:
*H04R 3/02* (2006.01)     *H03G 9/02* (2006.01)

(21) Application number: **18151923.2**

(22) Date of filing: **16.01.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(71) Applicant: **Hearezanz AB
211 75 Malmö (SE)**

(72) Inventors:
• **PHILIPSSON, John
247 35 Södra Sandby (SE)**
• **MARTINSON, Roger
211 16 Malmö (SE)**
• **WALDECK, Carl-Johan
224 76 Lund (SE)**

(74) Representative: **Hansson Thyresson AB
PO Box 73
201 20 Malmö (SE)**

(54) **A METHOD FOR PROCESSING DIGITAL AUDIO SIGNALS**

(57)    A method for processing digital audio signals comprising a plurality of samples, each sample having an amplitude. It comprises estimating power spectral density of each one of a plurality of audio files of a first type to provide an averaged power spectrum for each audio file, and calculating frequency dependent mean and standard deviation values of each frequency bin of the averaged power spectrum for each audio file. Further steps are calculating a headroom spectrum as an amount of which a frequency dependent maximum value that can be represented exceeds a maximum sample amplitude of the audio signal before reaching a controlled degree of saturation, amplifying the digital audio signals within the headroom spectrum in sound processing steps, and outputting the processed digital audio signals.

Fig. 4

**Description**

TECHNICAL FIELD

The present invention relates generally to a method for processing digital audio signals.

PRIOR ART

Normal and hearing-impaired listeners often wish to optimize an audio sound field and to customize audio systems and products. A system and method for optimizing audio is disclosed in US20060215844. The background of the invention disclosed therein is prior art systems that have built-in audio equalization systems that have been designed to alter the spectrum of the audio signal for improved listening experiences. Gains of a filter bank is adjusted by a user during an initial process and filter specifications for the user is later used to modify output of an audio signal.

Normally, it is desired to increase gain or signal level at specific frequencies. In analogue sound systems it is comparatively simple to achieve this without effects in other frequencies or frequency bands. When performing digital audio processing, there are many scenarios when one might wish to increase the amplitude of the audio content. Since digital audio is quantized with a fixed maximum value referred to as a saturation level, there is big problem with headroom when performing such operations. In this context, headroom in a digital signal is the amount of which the maximum value that can be represented exceeds the maximum level of the signal content. Especially when dealing with music, which is often mastered to utilize the entire bit resolution, leaving little to no headroom to work with. One work around is to simply lower the level of the signal, resulting in more headroom. However, this impacts quality as the resolution of the signal deteriorates.

SUMMARY OF THE INVENTION

An object of the invention is to provide a better method, taking into account the dynamic frequency content of the signal. In accordance with a first aspect of the invention, a special soft knee limiter, tuned to a statistical headroom ruled by a saturation tolerance is produced. This headroom can also be used as a conditional max value to the processing algorithms that are running before the limiter. One or many sound files that can be analyzed. These should be representative for the sound that is to be processed. In case of few sound files, each file may be broken up in intervals. This data can be collected from a representative file base beforehand, or runtime if the file to be processed is available.

The sound files are analyzed to get an averaged energy or power spectrum for each file. A central tendency is calculated for all of the analyzed files by averaging each frequency bin. The standard deviation spectrum is calculated in the same manner. Then the headroom spectrum is determined and the digital audio signals are amplified within the available headroom spectrum. In various embodiments, some samples of the digital audio signal will be above saturation level. These samples can be handled by a limiter, preferably a soft-knee limiter. Since the theoretical maximum level of the signal and our allowed gain compensation are known from headroom calculations, it is possible to tune the limiter to fit the signal optimally. Any samples out of range for a container the samples are transported in will compressed to fit the container.

BRIEF DESCRIPTION OF THE DRAWINGS

In order that the manner in which the above recited and other advantages and objects of the invention are obtained will be readily understood, a more particular description of the invention briefly described above will be rendered by reference to specific embodiments thereof which are illustrated in the appended drawings.

Understanding that these drawings depict only typical embodiments of the invention and are not therefore to be considered to be limiting of its scope, the invention will be described and explained with additional specificity and detail through the use of the accompanying drawings in which:

Fig. 1       is a schematic diagram showing a headroom in a typical music sound file,

Fig. 2a     is a schematic diagram showing a power spectral density of the sound file of Fig. 1,

Fig. 2b     is a schematic diagram showing mean headroom at different frequencies of the sound file of Fig. 1

Fig. 3       is a schematic diagram showing signal compression, signal limiter and a soft-knee limiter,

Fig. 4       is a schematic block diagram showing functional blocks of one embodiment of a system in accordance with the invention, and

Fig. 5       is a schematic diagram showing normal distribution and tolerance.

DETAILED DESCRIPTION

When performing audio processing, there are many scenarios when an increase of the amplitude of the audio content is desired. Since digital audio is quantized with a fixed maximum value, there is big problem with headroom when performing such operations. Especially when dealing with music, which is often mastered to utilize the entire bit resolution, leaving little to no headroom to work with. One work around is to simply lower the level of the signal, resulting in more headroom. However, this impacts quality as the resolution of the signal deteriorates.

DEFINITIONS

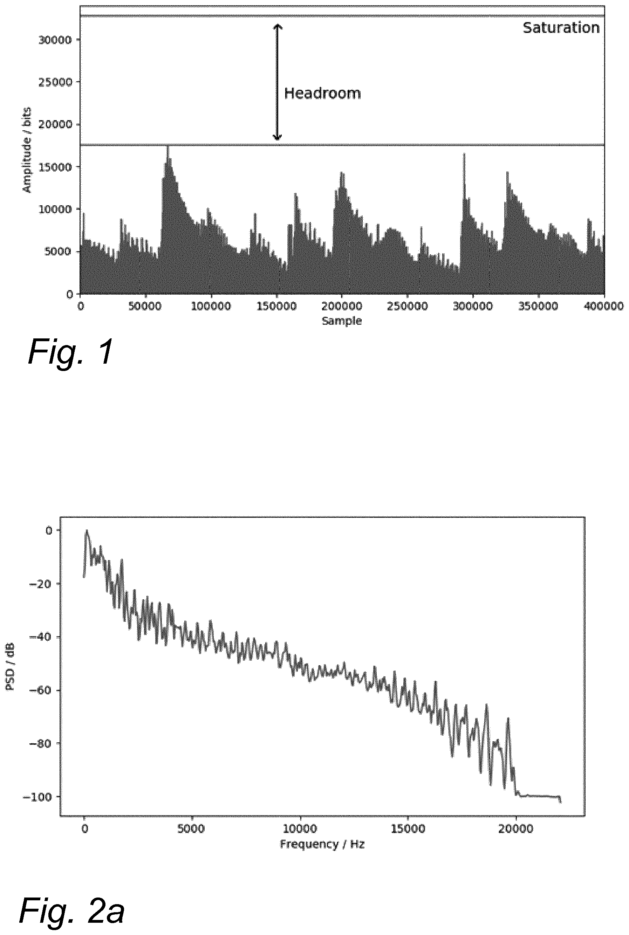

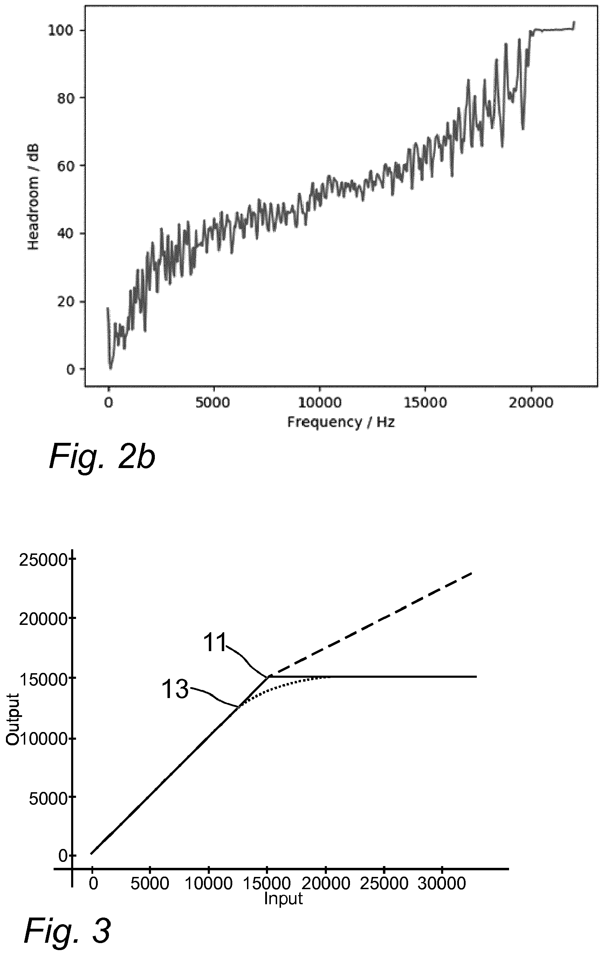

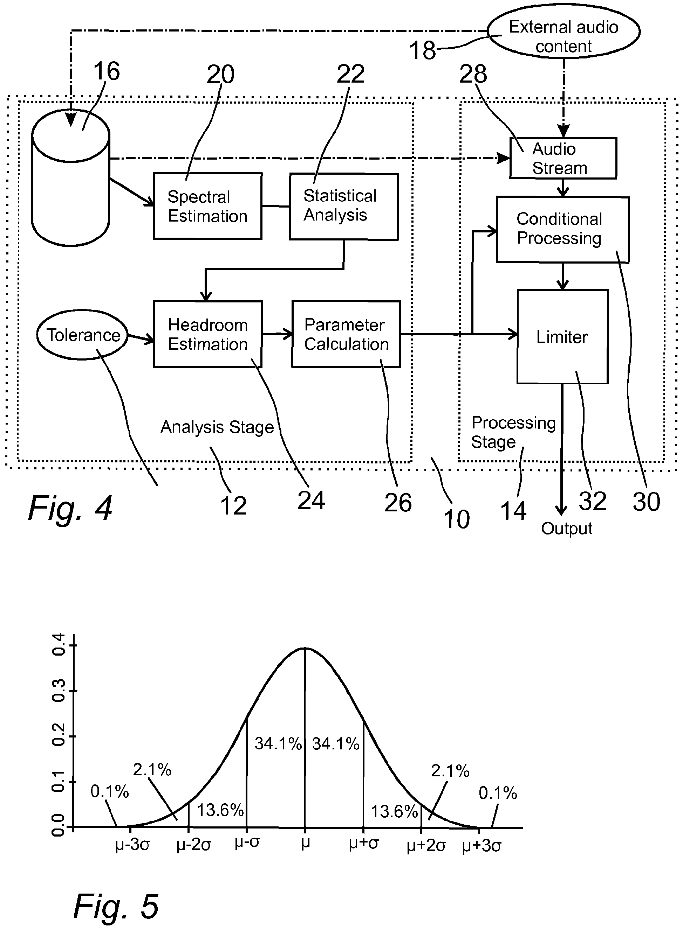

Headroom in a digital signal is the amount of which the maximum value that can be represented exceeds the maximum level of the signal content.
A bin or a frequency bin in this context is a segment of the frequency axis that "collect" the amplitude, magnitude or energy from a small range of frequencies, often resulting from a Fourier analysis.
Welch's method, named after P.D. Welch, is used for estimating the power of a signal at different frequencies: that is, it is an approach to spectral density estimation. The method is based on the concept of using periodogram spectrum estimates, which are the result of converting a signal from the time domain to the frequency domain. Welch's method is an improvement on the standard periodogram spectrum estimating method and on Bartlett's method, in that it reduces noise in the estimated power spectra in exchange for reducing the frequency resolution.
Compression is a tool to affect the dynamics of a signal. A simple audio compressor has two main settings. A threshold, above which the compressor is executed, and a ratio setting that governs how much the signal is compressed. An extreme case of compressor is a called a limiter setting a limit where the signal is not allowed to exceed the threshold.
In the example shown in Fig. 1 headroom is illustrated with a music file with a varying sound content amplitude. If the sound content amplitude exceeds the saturation limit, it will cause clipping, introducing distortion to the signal. In many cases, this headroom is smaller than the amount of amplification that is necessary to reach the wanted outcome of for example a filter. As shown in Fig. 1, sound is often very dynamic. Here the amplitude is shown over time with large variations. With enough statistical data, this dynamicity can be used to, in a controlled manner, fully utilize or exceed the headroom, still handling the cases where samples would saturate.
However, looking at the frequency content of the same file, as shown in Fig. 2a, there are some frequency bands where the headroom is much greater than in other frequency bands. By assuming that the audio content is utilizing the entire bit resolution it is possible use the data as shown in Fig. 2a to determine how much it is possible to amplify the signal in different frequency bins. By negating the mean spectrum, which is in decibels and normalized so that the highest value represents 0 as shown in Fig. 2a, the result effectively is the mean headroom at different frequency bins. The mean headroom value for a certain frequency now represents the mean gain that can be applied to the corresponding frequency component of a signal without saturation. This in turn implies that theoretically one half of the samples will in fact saturate. In accordance with the invention, this frequency based amplification is used when applying filtering and other signal processing to a digital audio signal. By using more audio files to base these statistics on, it is possible to obtain a more general curve that can be used to decide how much headroom signal processing is allowed to use, as long as this audio is representative for the digital audio signal that is processed.
Different behaviours of a compressor are shown in Fig. 3. The dashed line in Fig. 3 illustrates a typical compressor. Above a predefined threshold point 11 output is not allowed to follow input but will be limited. The threshold point is called "the knee" of the compressor. A limiter has a very sharp knee, as depicted by the continuous line. A gentler approach to this is to use what is called a "soft knee" or "over easy" as depicted by the dotted line. By gradually changing gradient in a circular behavior above a predefined knee threshold point 13 an abrupt limiting is avoided. Instead, a gradually increasing compression is obtained.
In one aspect of the invention as illustrated in Fig. 4, the two methods discussed above are combined to produce a special soft knee limiter, tuned to a statistical headroom ruled by a saturation tolerance. This headroom is also used as a conditional maximum value to the processing steps that are run before the limiter. One embodiment of a processing system 10 in accordance with the invention comprises an analysis stage 12 and a processing stage 14. In various embodiments, analysis stage 12 and processing stage 14 are arranged as separate systems and may comprise hardware and software components and also combinations thereof.
Stored audio content 16 comprises at least one digital audio file. When a digital audio file that will be used as external audio content 18 is available it is possible to use data from that file for further processing and a specific setting for that specific audio file. When there is no access to the external audio content in advance another approach can be used. In any case, a spectral estimation 20 is performed in an analysing step. During this step an averaged energy or power spectrum for each digital audio file in the stored audio content 16 is obtained. In various embodiments, Welch method is used for spectral estimation.
After spectral estimation, a statistical analysis 22 is performed. A central tendency or an average such as the arithmetic mean, the median or mode spectrum $\mu_f$ is calculated for all of the analysed files by averaging each frequency bin. In statistics, a central tendency (or measure of central tendency) is a central or typical value for a probability distribution. It may also be called a center or location of the distribution. Colloquially, measures of central tendency are often called averages. Then the spread between values, such as the variance or standard deviation spectrum $\sigma_{W_f}$ is calculated correspondingly. Frequency dependent mean and standard deviation calculation for the spectra can be made with the equation 1 and equation 2 as set out below:

$$\mu_f = \frac{1}{n}\sum_{i=0}^{n} w_f(i) \qquad \text{Equation 1.}$$

$$\sigma_{w_f} = \sqrt{\frac{1}{n}\sum_{i=0}^{n}(w_f(i) - \mu_f)^2} \qquad \text{Equation 2}$$

Where *w(i)* is the Welch spectrum for a specific audio file and $w_f(i)$ is a specific frequency bin for this spectrum.

A result from the statistical analysis 22 is used in a headroom estimation 24, c.f. Fig. 5. The headroom is estimated or calculated in terms of tolerance. By approximating the sound samples with a normal distribution, it is possible to establish a tolerance in percent of samples that will be allowed to saturate. With the relationship shown in Fig. 5, equations 3 and 4 as set out below is used to achieve a tolerance of certain percentage.

$$headroom_f = -1 * \mu_f \qquad \text{Equation 3}$$

$$headroom_{\gamma f} = headroom_f - \gamma\sigma_{wf} = -1 * \mu_f - \gamma\sigma_{w_f} \quad \text{Equation 4}$$

Where $\gamma$ is chosen in accordance with a selected tolerance in the normal distribution graph shown in Fig. 5. In this context, $\gamma$ corresponds to the number of standard deviations deducted or added to the mean value.

An average headroom can be used as a limit for how much the audio processing is allowed to amplify the signal for each frequency band. Since there is a resulting tolerance degree of saturation present, a compressor is needed to cover a scenario when the processed signal otherwise would saturate.

The headroom spectrum generated above is used in a parameter calculation 26 for calculating parameters both for any conditional processing 30 and for a limiter 32. The processing is not allowed to amplify the signal beyond the headroom in any given frequency band. Compressor parameters are tuned to match the highest amplification made by the processing algorithm(s), thereby ensuring a smooth transition to this value without saturation.

The external audio content is input to the processing stage 14 as an audio stream 28. The audio stream 28 is processed in the conditional processing 30. The conditional processing 30 can be any kind of signal processing and parameters from the parameter calculation 26 are used to maintain a signal level within the headroom calculated during headroom estimation. It should be noted, that the processed signal level can exceed the maximum value for a sample container, given that later processing, for instance in limiter 32 can handle it. The limiter 32 will handle cases like this to ensure that the signal will be representable after the processing stage 14.

Samples that would cause saturation will be handled gracefully by the limiter 32 beeing a soft-knee limiter. In a soft-knee compressor, onset of gain reduction occurs gradually after the signal has exceeded a threshold value. Since the theoretical maximum level of the signal and the allowed gain compensation are known from the headroom calculations, it is now possible to tune the limiter to fit the signal optimally. Any samples out of range for the container samples are transported in will be compressed to fit the container.

While certain illustrative embodiments of the invention have been described in particularity, it will be understood that various other modifications will be readily apparent to those skilled in the art without departing from the scope and spirit of the invention. Accordingly, it is not intended that the scope of the claims appended hereto be limited to the description set forth herein but rather that the claims be construed as encompassing all equivalents of the present invention which are apparent to those skilled in the art to which the invention pertains.

**Claims**

1. A method for processing digital audio signals comprising a plurality of samples, each sample having an amplitude, comprising

   estimating signal frequency content of each one of a plurality of audio files of a first type to provide an average signal frequency content,
   calculating a measure of frequency dependent central tendency and a spread between frequency content values of each frequency bin of the signal frequency content of each of said audio files,
   calculating a headroom spectrum as an amount of which a frequency dependent maximum value that can be represented exceeds a maximum sample amplitude of the audio signal before reaching a controlled degree of saturation,
   amplifying the digital audio signals within the headroom spectrum in sound processing steps, and
   outputting the processed digital audio signals.

2. The method of claim 1, comprising estimating signal frequency content by estimating energy spectral density of each one of a plurality of audio files of a first type to provide an averaged energy spectrum for each audio file.

3. The method of claim 1, comprising calculating a measure of frequency dependent central tendency and a spread between frequency content values by calculating frequency dependent mean and standard deviation values of each frequency bin of the averaged energy spectrum for each audio file.

4. The method of any of claims 1-3, comprising calculating the headroom to allow a tolerance in percent of audio samples that are allowed to saturate.

5. The method of claim 4, comprising calculating the headroom using the equatations:

$$headroom_f = -1 * \mu_f$$

where

$$headroom_{\gamma f} = headroom_f - \gamma \sigma_{wf} = -1 * \mu_f - \gamma \sigma_{w_f}$$

mean value $\mu_f = \frac{1}{n} \sum_{i=0}^{n} W_f(i)$ and

standard deviation $\sigma_{w_f} = \sqrt{\frac{1}{n} \sum_{i=0}^{n} (w_f(i) - \mu_f)^2}$

and, $\gamma$ being the number of standard deviations deducted or added to the mean value.

6. The method of any of claims 1-3, comprising limiting the digital audio signals to a signal level at a threshold value (11) below saturation after said sound processing steps.

7. The method of claim 6, comprising gradually reducing gain to the digital audio signal when a signal level of the digital audio signal exceeds a predefined knee threshold value (13), said predefined knee threshold value (13) being lower than the level of saturation.

*Fig. 1*

*Fig. 2a*

Fig. 2b

Fig. 3

Fig. 4

Fig. 5

Europäisches
Patentamt

European
Patent Office

Office européen
des brevets

## EUROPEAN SEARCH REPORT

Application Number

EP 18 15 1923

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 00/47014 A1 (UNIV MELBOURNE [AU]; BLAMEY PETER JOHN [AU]; JAMES CHRISTOPHER JOHN [A) 10 August 2000 (2000-08-10)<br>* figures 4, 5 *<br>* page 1, line 3 - line 7 *<br>* page 8, line 2 - line 6 *<br>* page 9, line 10 - page 10, line 12 *<br>* page 4, line 1 - line 4 *<br>----- | 1-7 | INV.<br>H04R3/02<br>H03G9/02 |
| X | US 2015/117685 A1 (REISS JOSHUA D [GB] ET AL) 30 April 2015 (2015-04-30)<br>* paragraphs [0001], [0085], [0099], [0100], [0102], [0104], [0105] *<br>----- | 1-7 | |
| A | WO 03/015468 A1 (GN RESOUND AS [DK])<br>20 February 2003 (2003-02-20)<br>* the whole document *<br>----- | 1-7 | |

|  |
|---|
| TECHNICAL FIELDS SEARCHED (IPC) |
| H04R<br>H03G |

The present search report has been drawn up for all claims

| Place of search | Date of completion of the search | Examiner |
|---|---|---|
| The Hague | 28 May 2018 | Mendoza Lopez, Jorge |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 15 1923

This annex lists the patent family members relating to the patent documents cited in the above-mentioned European search report.
The members are as contained in the European Patent Office EDP file on
The European Patent Office is in no way liable for these particulars which are merely given for the purpose of information.

28-05-2018

| Patent document cited in search report | | Publication date | Patent family member(s) | | Publication date |
|---|---|---|---|---|---|
| WO 0047014 | A1 | 10-08-2000 | AU | 761865 B2 | 12-06-2003 |
| | | | CA | 2361544 A1 | 10-08-2000 |
| | | | DE | 69933141 T2 | 16-08-2007 |
| | | | EP | 1172020 A1 | 16-01-2002 |
| | | | JP | 2002536930 A | 29-10-2002 |
| | | | US | 6731767 B1 | 04-05-2004 |
| | | | WO | 0047014 A1 | 10-08-2000 |
| US 2015117685 | A1 | 30-04-2015 | GB | 2503867 A | 15-01-2014 |
| | | | US | 2015117685 A1 | 30-04-2015 |
| | | | WO | 2013167884 A1 | 14-11-2013 |
| WO 03015468 | A1 | 20-02-2003 | CN | 1640190 A | 13-07-2005 |
| | | | DK | 1433359 T3 | 27-08-2012 |
| | | | DK | 2369858 T3 | 19-01-2015 |
| | | | EP | 1433359 A1 | 30-06-2004 |
| | | | EP | 2369858 A2 | 28-09-2011 |
| | | | JP | 4252898 B2 | 08-04-2009 |
| | | | JP | 2004538734 A | 24-12-2004 |
| | | | US | 2003072464 A1 | 17-04-2003 |
| | | | US | 2003081804 A1 | 01-05-2003 |
| | | | US | 2006008101 A1 | 12-01-2006 |
| | | | US | 2008175422 A1 | 24-07-2008 |
| | | | WO | 03015468 A1 | 20-02-2003 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060215844 A